# EUROPÄISCHE PATENTSCHRIFT

(11) **EP 1 058 178 B1**
(45) Veröffentlichungstag und Bekanntmachung des Hinweises auf die Patenterteilung: **14.11.2007**
(21) Anmeldenummer: 99110579.2
(22) Anmeldetag: 01.06.1999
(51) Int. Cl.: G06F 21/02, H01L 27/02

(54) **Schutzschaltung**
Protective circuit
Circuit de protection

(43) Veröffentlichungstag der Anmeldung: 06.12.2000
(73) Patentinhaber: Infineon Technologies AG, 81669 München (DE)
(72) Erfinder: Brücklmayr, Franz, 86916 Kaufering (DE)
(74) Vertreter: Epping - Hermann - Fischer

(56) Entgegenhaltungen:
- EP-A- 0 378 306
- US-A- 4 811 288
- US-A- 5 533 123

## Beschreibung

Die Erfindung betrifft eine Schutzschaltung zum Schutz einer in einem Gehäuse untergebrachten elektrischen Schaltung vor manipulativen Eingriffen von außen.

In elektronischen Systemen sind oft sensitive und vertrauliche Informationen abgespeichert, die vor einem unerlaubten Zugriff geschützt werden müssen. Eine derartige vertrauliche Information ist beispielsweise eine persönliche Identifikationsnummer (PIN) oder Paßwörter und Zugriffscodes.

Bei integrierten Schaltkreisen (IC) werden die darin enthaltenen vertraulichen Daten bisher durch elektrische Schutzleitungen geschützt, die in der Oberfläche der integrierten Schaltung verlaufen. Dabei werden eine Vielzahl von Schutzleitungen mit einem möglichst geringen Abstand in verschiedenen Metallisierungslagen des integrierten Schaltkreises vorgesehen. Eine derartige Schutzschaltung ist aus der EP 0 378 306 bekannt, bei der ein abgesicherter Bereich des integrierten Schaltkreises durch zwei Schutzleitungen in zwei verschiedenen Metallisierungsebenen angebracht sind, um den integrierten Schaltkreis vor einem Eingriff von außen zu schützen.

Zur Erkennung von Eingriffen werden bei herkömmlichen Schutzschaltungen die Schutzleitungen im Betriebsfall der integrierten Schaltungen an dem ersten Ende der Schutzleitung durch eine Signaleinspeiseeinrichtung mit einem Signal beaufschlagt, das am anderen Ende der Schutzleitung durch eine Signalerfassungseinrichtung erfaßt wird. Ein Eingriff in das Gehäuse der integrierten Schaltung wird hierbei dadurch erkannt, daß das von der Signaleinspeiseeinrichtung an dem einen Ende der Schutzleitung eingespeiste Signal am anderen Ende der Schutzleitung nicht ankommt und durch die Signalerfassungseinrichtung nicht erfaßt wird. Damit die Ansteuerlogik für die Signaleinspeiseeinrichtungen und die Auswertelogik für die Signalerfassungseinrichtungen nicht zu komplex wird und in dem Vergleich zu der zu sichernden elektrischen Schaltung nicht zu großflächig wird, werden sehr lange Schutzleitungen verwendet, die mäanderförmig verlaufend und einander überlagernd die in dem Gehäuse untergebrachte zu schützende Schaltung vollständig abdecken.

Um einen Eingriff von außen vornehmen zu können, muß diejenige Person, welche den Eingriff vornehmen will, die Schutzleitungen identifizieren, um sie gegebenenfalls kurzschließen zu können. Die Identifikation von Schutzleitungen kann durch bildgebende Verfahren, beispielsweise durch ein Elektronenmikroskop, erfolgen. Hierzu wird eine elektrische Spannung mittels einer Nadel auf eine Schutzleitung aufgebracht und durch das Elektronenmikroskop die Verbreitung dieser Spannung auf der integrierten Schaltung bzw. dem Chip beobachtet.

Bei herkömmlichen Schutzschaltungen wird das Aufbringen einer Spannung auf die Schutzleitung durch die Signalerfassungseinrichtungen am Ende der Schutzleitungen erkannt, da diese aufgebrachte Spannung von dem Sendesignal überlagert wird. Dieser Schutz ist jedoch nur gegeben, wenn die Signalerfassungseinrichtungen im eingeschalteten Zustand der integrierten Schaltung in Betrieb sind.

Befindet sich jedoch die zu schützende integrierte Schaltung im ausgeschalteten Zustand, sind auch die Signalerfassungseinrichtungen ausgeschaltet, und es kann mittels einer Nadel eine Spannung auf die Schutzleitung aufgebracht werden, deren Ausbreitung beispielsweise mittels eines Elektronenmikroskops verfolgt werden kann. Die eingreifende Person kann dann die identifizierte, mäanderförmig verlaufende Schutzleitung mittels einer elektrischen Überbrückung kurzschließen. Es können nach dem Kurzschluß mechanische Manipulationen an der integrierten Schaltung in denjenigen Bereichen vorgenommen werden, die durch die kurzgeschlossene Schutzleitung abgedeckt sind. Wird die integrierte Schaltung nunmehr erneut eingeschaltet, erkennt die Signalerfassungseinrichtung aufgrund des Kurzschlusses nicht mehr, daß die eigentliche Schutzleitung aufgrund mechanischer Manipulation unterbrochen worden ist.

Es wurde versucht, derartige Manipulationen dadurch zu verhindern, daß man Signalerfassungseinrichtungen vorsieht, die Laufzeitunterschiede des eingespeisten Signals erfassen. Das durch die Signaleinspeiseeinrichtung eingespeiste Signal gelangt aufgrund des manipulativen Kurzschlusses in einer kürzeren Zeit zu der Signalerfassungseinrichtung.

Derartige Einrichtungen sind jedoch sehr aufwendig und zudem äußerst schwierig zu kalibrieren. Darüber hinaus können Laufzeitunterschiede nur sehr grob erfaßt werden

In der US 4 811 288 ist ein Sicherheitsbauelement zum Schutz gespeicherter Daten beschrieben, bei dem ein Gehäuse aus keramischen Platten vorhanden ist. Die Platten verfügen jeweils über ein Paar von Dünnfilmleiterbahnsegmenten in einer mäanderförmigen Anordnung. Eine Unterbrechung oder ein Kurzschluss der Leiterbahnen veranlasst eine Reset-Schaltung, die gespeicherten Daten zu löschen.

Es ist daher die Aufgabe der vorliegenden Erfindung, eine Schutzschaltung zu schaffen, die manipulative Eingriffe in jedem Fall auch im ausgeschalteten Zustand der zu schützenden Schaltung sicher und mit geringem Aufwand verhindert.

Diese Aufgabe wird erfindungsgemäß durch eine Schutzschaltung mit den im Patentanspruch 1 angegebenen Merkmalen gelöst.

Weitere vorteilhafte Ausgestaltungen der Erfindung sind in den Unteransprüchen angegeben.

Hierzu schafft die Erfindung eine Schutzschaltung zum Schutz einer in einem Gehäuse untergebrachten elektrischen Schaltung vor Eingriffen mit einer Vielzahl von in dem Gehäuse verlaufenden Schutzleitungen und mit einer Vielzahl von Halbleiterschaltelementen, die im ausgeschalteten Zustand der elektrischen Schaltung mehrere Schutzleitungen miteinander verbindet.

Bei einer vorteilhaften Weiterbildung der erfindungsgemäßen Schutzschaltung werden durch die Halbleiterschaltelemente im ausgeschalteten Zustand der elektrischen Schaltung alle Schutzleitungen miteinander verbunden.

Dies bietet den Vorteil, daß diejenige Person, welche den manipulativen Eingriff vornehmen will, keinerlei Strukturen der Schutzleitungen erkennen kann.

Bei einer weiteren vorteilhaften Ausgestaltung der erfindungsgemäßen Schutzschaltung ist die elektrische Schaltung eine in dem Gehäuse untergebrachte integrierte Schaltung.

Bei einer weiteren vorteilhaften Ausgestaltung der Erfindung verlaufen die Schutzleitungen mäanderförmig an der Oberfläche des Gehäuses.

Dies bietet den besonderen Vorteil, daß eine große Gehäuseoberfläche mit relativ wenigen Schutzleitungen geschützt werden kann.

Bei einer weiteren vorteilhaften Ausgestaltung der erfindungsgemäßen Schutzschaltung verlaufen die Schutzleitungen in verschiedenen Metallisierungsebenen der integrierten Schaltung.

Dies bietet den besonderen Vorteil, daß die Schutzleitungen beliebig in mehreren Ebenen verlaufen können und sich somit auch kreuzen können. Hierdurch wird das Erkennen von Schutzleiterstrukturen durch die eingreifende Person zusätzlich erschwert.

Bei einer weiteren vorteilhaften Ausgestaltung der erfindungsgemäßen Schutzschaltung werden die Halbleiterschaltelemente im eingeschalteten Zustand der elektrischen Schaltung durch eine Steuereinrichtung gesperrt.

Bei einer weiteren vorteilhaften Ausgestaltung der erfindungsgemäßen Schutzschaltung ist jedes Halbleiterschaltelement über eine eigene Steuerleitung mit der Steuereinrichtung verbunden.

Dies bietet den besonderen Vorteil, daß ein manipulativer Eingriff auf die Steuerleitungen der Halbleiterschaltelemente erschwert wird.

Bei einer weiteren vorteilhaften Ausgestaltung der erfindungsgemäßen Schutzschaltung werden mehrere Gruppen von Halbleiterschaltelementen jeweils über eigene Steuerleitungen mit der Steuereinrichtung verbunden.

Bei einer weiteren vorteilhaften Ausgestaltung der erfindungsgemäßen Schutzschaltung sind die Transistoren selbstleitende Feldeffekttransistoren.

Dies bietet den besonderen Vorteil, daß die Halbleiterschaltelemente einfach und mit der Technologie der integrierten Schaltung herstellbar sind.

Bei einer weiteren vorteilhaften Ausgestaltung der erfindungsgemäßen Schutzschaltung verbinden die Schutzleitungen jeweils eine Signaleinspeiseeinrichtung mit einer zugehörigen Signalerfassungseinrichtung.

Bei einer weiteren vorteilhaften Ausgestaltung der erfindungsgemäßen Schutzschaltung erzeugt die Signalerfassungseinrichtung ein Warnsignal, wenn im ausgeschalteten Zustand der elektrischen Schaltung eine Spannung auf die zugehörige Schutzleitung aufgebracht wird.

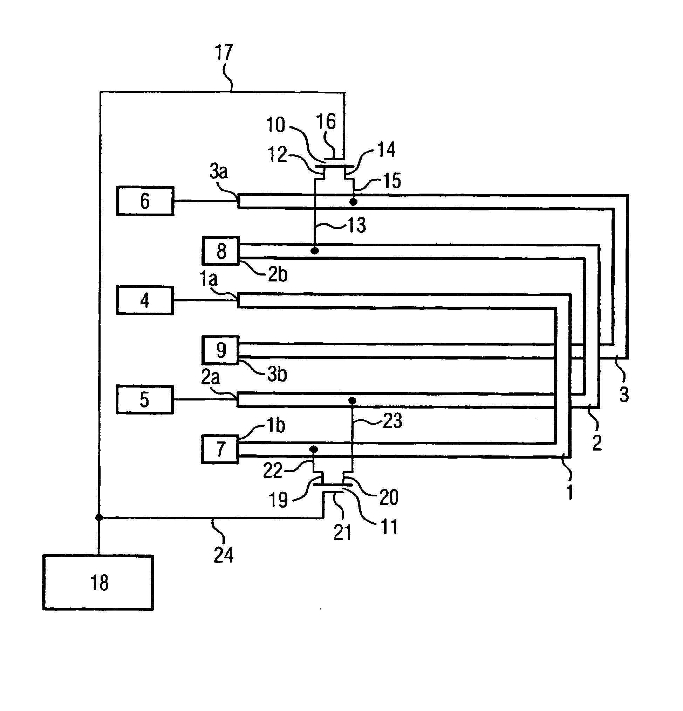

Im weiteren wird eine bevorzugte Ausführungsform der erfindungsgemäßen Schutzschaltung anhand der beigefügten Zeichnung mit der einzigen Figur beschrieben.

Die gezeigte Ausführungsform zeigt schematisch die erfindungsgemäße Schutzschaltung für drei Schutzleitungen mit zwei Halbleiterschaltelementen. In der praktischen Umsetzung ist die Anzahl der Schutzleitungen sowie die Anzahl der Halbleiterschaltelemente wesentlich höher. Die Schutzleitungen verlaufen zudem nicht nur, wie in der Figur dargestellt, U-förmig, sondern können auch in einer beliebigen Form und in beliebigen Metallisierungsebenen verlaufen.

Die Figur zeigt drei U-förmig verlaufende Schutzleitungen 1, 2, 3, die an der Oberfläche eines Gehäuses untergebracht sind. In dem Gehäuse befindet sich eine elektrische Schaltung, die durch die erfindungsgemäße Schutzschaltung vor manipulativen Eingriffen geschützt wird.

Die Schutzleitungen 1, 2, 3 weisen jeweils ein erstes Ende 1a, 2a, 3a und ein zweites Ende 1b, 2b, 3b auf. Die ersten Enden 1a, 2a, 3a der Schutzleitungen 1, 2, 3 sind mit Signaleinspeiseeinrichtungen 4, 5, 6 verbunden. Die zweiten Enden 1b, 2b, 3b der Schutzleitungen 1, 2, 3 sind jeweils an Signalerfassungseinrichtungen 7, 8, 9 angeschlossen.

Die Signaleinspeiseeinrichtungen 4, 5, 6 speisen jeweils ein Signal in die zugehörige Schutzleitung 1, 2, 3 ein, welches durch die entsprechende Signalerfassungseinrichtung 7, 8, 9 erfaßt wird.

Die gezeigte erfindungsgemäße Schutzschaltung enthält zudem zwei Halbleiterschaltelemente 10, 11. In der gezeigten Ausführungsform handelt es sich hierbei um selbstleitende Feldeffekttransistoren.

In dem gezeigten Beispiel ist der Source-Anschluß 12 des ersten Feldeffekttransistors 10 mit der Schutzleitung 2 über eine Anschlußleitung 13 und der Drain-Anschluß 14 über eine Anschlußleitung 15 mit der Schutzleitung 3 verbunden. Der Gate-Anschluß 16 des ersten Feldeffekttransistors 10 ist über eine erste Steuerleitung 17 mit einer Steuerschaltung 18 verbunden.

Der zweite Feldeffekttransistor 11 besitzt einen Source-Anschluß 19, einen Drain-Anschluß 20 und einen Gate-Anschluß 21. Der Source-Anschluß 19 des zweiten Feldeffekttransistors 11 ist über eine Anschlußleitung 22 mit der ersten Schutzleitung 1 verbunden. Der Drain-Anschluß 20 des ersten Feldeffekttransistors 11 ist über eine Anschlußleitung 23 an die zweite Schutzleitung 2 angeschlossen. Der Gate-Anschluß 21 des zweiten Feldeffekttransistors 11 wird über eine Steuerleitung 24 durch die Steuerschaltung 18 angesteuert.

Im eingeschalteten Zustand der integrierten Schaltung bringt die Steuerschaltung 18 über die Steuerleitungen 17, 24 die Feldeffekttransistoren 10, 11 in den sperrenden Zustand. In diesem Falle sind die Schutzleitungen 1, 2, 3 voneinander elektrisch getrennt. Die Schutzleitung 1 ist nicht über die Leitungen 22, 23 mit der Schutzleitung 2 verbunden, und die Schutzleitung 3 wird nicht über die Anschlußleitungen 13, 15 mit der Schutzleitung 2 kurzgeschlossen.

Wird nunmehr im eingeschalteten Zustand der integrierten Schaltung eine mechanische Manipulation vorgenommen, kommt es zu einer Unterbrechung von mindestens einer der Schutzleitungen 1, 2, 3, so daß die zugehörige Signalerfassungseinrichtung 7, 8, 9 das durch die Signaleinspeiseeinrichtung 4, 5, 6 eingespeiste Signal nicht mehr erfaßt. Der manipulative Eingriff wird somit erkannt.

Im ausgeschalteten Zustand der integrierten Schaltung sind die selbstleitenden Feldeffekttransistoren, auch ohne daß eine Versorgungsspannung vorliegt, selbstleitend. Bei der gezeigten Ausführungsform ist die Schutzleitung 1 über die Anschlußleiturigen 22, 23 über den selbstleitenden Feldeffekttransistor 11 mit der Schutzleitung 2 verbunden. Die Schutzleitung 2 ist ihrerseits über die Anschlußleitungen 13, 15 über den selbstleitenden Feldeffekttransistor 10 mit der Schutzleitung 3 verbunden. In der gezeigten Ausführungsform sind daher alle Schutzleitungen im ausgeschalteten Zustand der integrierten Schaltung miteinander verbunden.

Eine Person, die zur Vornahme eines manipulativen Eingriffs versucht, eine Spannung auf eine der Schutzleitungen 1, 2, 3 zu deren Identifikation aufzubringen, hat keine Möglichkeit, die Struktur der Schutzleitung zu erfassen. Die mittels einer Nadel aufgebrachte Spannung wird aufgrund der Verbindung der Schutzleitungen 1, 2, 3 untereinander an alle Schutzleitungen angelegt. Versucht die manipulierende Person mittels eines Elektronenmikroskops, eine Schutzleitung zu erkennen, ist dies unmöglich, weil alle Schutzleitungen gleichzeitig aufgrund der angelegten Spannung aufleuchten. Die manipulierende Person kann daher nicht erkennen, wie sie eine Schutzleitung mittels einer Überbrückung kurzschließt.

Bei der gezeigten bevorzugten Ausführungsform sind die selbstleitenden Feldeffekttransistoren jeweils über eigene Steuerleitungen 17, 21 mit der Steuerschaltung 18 verbunden. Da bei der praktischen Umsetzung eine hohe Anzahl von Feldeffekttransistoren vorgesehen sind, können Steuerleitungen für Untergruppen von Transistoren vorgesehen werden.

Die Aktivierung der Halbleiterschaltelemente 10, 11 erfolgt vorzugsweise nicht durch ein gemeinsames Steuersignal, sondern durch getrennte Steuersignale, welche durch die Steuerschaltung 18 mittels eines Software-Programms erzeugt werden. Auch eine beliebige, fest verdrahtete Steuerlogik ist möglich. Die in der dargestellten Ausführungsform gezeigten Schutzleitungen 1, 2, 3 verlaufen einander überlappend vorzugsweise in beliebigen Mustern auf mehreren Metallisierungsebenen der integrierten Schaltung.

Die in der bevorzugten Ausführungsform gezeigten Schaltelemente 10, 11 können durch beliebige Schaltbauelemente realisiert werden, die im ausgeschalteten bzw. deaktivierten Zustand die Anschlußleitungen 13, 15 bzw. 22, 23 verbinden. Es kann sich beispielsweise um beliebige selbstleitende Halbleiterschaltbauelemente handeln. Auch eine Realisierung mit diskreten Schaltbauelementen, wie beispielsweise Relais, ist möglich.

Bei einer bevorzugten Ausführungsform erkennen die Signalerfassungseinrichtungen 7, 8, 9 auch im ausgeschalteten Zustand der integrierten Schaltung eine zu Manipulationszwecken auf die Schutzleitungen 1, 2, 3 aufgebrachte Spannung und erzeugen ein entsprechendes Warnsignal.

Dies kann beispielsweise dadurch erreicht werden, daß die Signaleinspeiseeinrichtungen 4, 5, 6 und die Signalerfassungseinrichtungen 7, 8, 9 über eine eigene Spannungsversorgung verfügen, die von der Spannungsversorgung der zu schützenden integrierten Schaltung getrennt ist.

Die vorliegende erfindungsgemäße Schutzschaltung bietet einen einfach realisierbaren und effektiven Schutz gegenüber manipulativen Eingriffen in ein Gehäuse, in dem sich eine elektrische Schaltung mit sensitiven bzw. vertraulichen Daten befindet. Die erfindungsgemäße Schutzschaltung gewährleistet insbesondere einen Schutz vor manipulativen Eingriffen im ausgeschalteten Zustand der elektrischen Schaltung, indem sie eine Identifikation der Schutzleitungen durch Anlegen einer Spannung verhindert.

## Patentansprüche

1. Schutzschaltung zum Schutz einer in einem Gehäuse untergebrachten elektrischen Schaltung vor Eingriffen mit einer Vielzahl von im Gehäuse verlaufenden Schutzleitungen (1, 2, 3), mit einer Steuereinrichtung (18) und mit einer Vielzahl von Schaltelementen (10, 11), die mit der Steuereinrichtung (18) verbunden sind, wobei die Schaltelemente (10, 11)
- im eingeschalteten Zustand der elektrischen Schaltung durch die Steuereinrichtung (18) gesperrt werden und
- im ausgeschalteten Zustand der elektrischen Schaltung mehrere Schutzleitungen (1, 2, 3) miteinander verbinden.

2. Schutzschaltung zum Schutz einer in einem Gehäuse untergebrachten elektrischen Schaltung vor Eingriffen nach Anspruch 1,
**dadurch gekennzeichnet,**
**daß** die Schaltelemente (10, 11) alle Schutzleitungen miteinander verbindet.

3. Schutzschaltung zum Schutz einer in einem Gehäuse untergebrachten elektrischen Schaltung vor Eingriffen nach Anspruch 1 oder 2,
**dadurch gekennzeichnet,**
**daß** die elektrische Schaltung eine in dem Gehäuse integrierte Schaltung ist.

4. Schutzschaltung zum Schutz einer in einem Gehäuse untergebrachten elektrischen Schaltung vor Eingriffen nach einem der vorhergehenden Ansprüche,
**dadurch gekennzeichnet,**
**daß** die Schutzleitungen (1, 2, 3) mäanderförmig an der Oberfläche des Gehäuses verlaufen.

5. Schutzschaltung zum Schutz einer in einem Gehäuse untergebrachten elektrischen Schaltung vor Eingriffen nach einem der vorhergehenden Ansprüche,
**dadurch gekennzeichnet,**
**daß** die Schutzleitungen (1, 2, 3) in verschiedenen Metallisierungsebenen der integrierten Schaltung verlaufen.

6. Schutzschaltung zum Schutz einer in einem Gehäuse untergebrachten elektrischen Schaltung vor Eingriffen nach einem der vorhergehenden Ansprüche,
**dadurch gekennzeichnet, daß** die Schaltelemente (10, 11) im eingeschalteten Zustand der elektrischen Schaltung durch eine Steuereinrichtung (18) gesperrt werden.

7. Schutzschaltung zum Schutz einer in einem Gehäuse untergebrachten elektrischen Schaltung vor Eingriffen nach einem der vorhergehenden Ansprüche,
**dadurch gekennzeichnet,**
**daß** jedes Schaltelement (10, 11) über eine eigene Steuerleitung mit der Steuereinrichtung (18) verbunden ist.

8. Schutzschaltung zum Schutz einer in einem Gehäuse untergebrachten elektrischen Schaltung vor Eingriffen nach einem der vorhergehenden Ansprüche 1 bis 6,
**dadurch gekennzeichnet,**
**daß** mehrere Gruppen von Schaltelementen (10, 11) jeweils über eine Steuerleitung mit der Steuereinrichtung verbunden sind.

9. Schutzschaltung zum Schutz einer in einem Gehäuse untergebrachten elektrischen Schaltung vor Eingriffen nach einem der vorhergehenden Ansprüche,
**dadurch gekennzeichnet,**
**daß** die Schaltelemente (10, 11) Transistoren sind.

10. Schutzschaltung zum Schutz einer in einem Gehäuse untergebrachten elektrischen Schaltung vor Eingriffen nach Anspruch 9,
**dadurch gekennzeichnet,**
**daß** die Transistoren selbstleitende Feldeffekttransistoren sind.

11. Schutzschaltung zum Schutz einer in einem Gehäuse untergebrachten elektrischen Schaltung vor Eingriffen nach einem der vorhergehenden Ansprüche,
**dadurch gekennzeichnet,**
**daß** die Schutzleitungen (1, 2, 3) jeweils eine Signaleinspeiseeinrichtung (4, 5, 6) mit einer Signalerfassungseinrichtung (7, 8, 9) verbinden.

12. Schutzschaltung zum Schutz einer in einem Gehäuse untergebrachten elektrischen Schaltung vor Eingriffen nach Anspruch 11,
**dadurch gekennzeichnet,**
**daß** die Signalerfassungseinrichtung (7, 8, 9) einen Laufzeitunterschied bei Kurzschluß der zugehörigen Schutzleitung (1, 2, 3) erfaßt.

13. Schutzschaltung zum Schutz einer in einem Gehäuse untergebrachten elektrischen Schaltung vor Eingriffen nach Anspruch 11 oder 12,
**dadurch gekennzeichnet,**
**daß** im ausgeschalteten Zustand der Schaltung die Signalerfassungseinrichtung (7, 8, 9) eine auf die Schutzleitung (1, 2, 3) aufgebrachte Spannung erfaßt und ein Warnsignal erzeugt.

## Claims

1. Protection circuit for protecting an electrical circuit accommodated in a housing against intrusions, with a multiplicity of protective lines (1, 2, 3) which run inside the housing, with a control device (18) and with a multiplicity of switching elements (10, 11), which are connected to the control device (18), wherein the switching elements (10, 11)
- in the switched-on state of the electrical circuit, are inhibited by the control device (18) and
- in the switched-off state of the electrical circuit, connect a plurality of protective lines (1, 2, 3) to one another.

2. Protection circuit for protecting an electrical circuit accommodated in a housing against intrusions according to Claim 1, **characterised in that** the switching element (10, 11) connects all protective lines to one another.

3. Protection circuit for protecting an electrical circuit accommodated in a housing against intrusions according to Claim 1 or 2, **characterised in that** the electrical circuit is a circuit integrated in the housing.

4. Protection circuit for protecting an electrical circuit accommodated in a housing against intrusions according to one of the preceding claims, **characterised in that**, the protective lines (1, 2, 3) follow a meandering path on the surface of the housing.

5. Protection circuit for protecting an electrical circuit accommodated in a housing against intrusions according to one of the preceding claims, **characterised in that** the protective lines (1, 2, 3) run in various metallisation layers of the integrated circuit.

6. Protection circuit for protecting an electrical circuit accommodated in a housing against intrusions, according to one of the preceding claims, **characterised in that** the switching elements (10, 11) in the switched-on state of the electrical circuit are inhibited by a control device (18).

7. Protection circuit for protecting an electrical circuit accommodated in a housing against intrusions according to one of the preceding claims, **characterised in that** each switching element (10, 11) is connected by means of its own control line to the control device (18).

8. Protection circuit for protecting an electrical circuit accommodated in a housing against intrusions according to one of the preceding Claims 1 to 6, **characterised in that** a plurality of groups of switching elements (10, 11) are each connected by means of a control line to the control device.

9. Protection circuit for protecting an electrical circuit accommodated in a housing against intrusions according to one of the preceding claims, **characterised in that** the switching elements (10, 11) are transistors.

10. Protection circuit for protecting an electrical circuit accommodated in a housing against intrusions according to claim 9, **characterised in that** the transistors are depletion-mode field effect transistors.

11. Protection circuit for protecting an electrical circuit accommodated in a housing against intrusions according to one of the preceding claims, **characterised in that** the protective lines (1, 2, 3) each connect a signal-input device (4, 5, 6) to a signal detection device (7, 8, 9).

12. Protection circuit for protecting an electrical circuit accommodated in a housing against intrusions according to Claim 11, **characterised in that** the signal detection device (7, 8, 9) detects a delay-time difference on short-circuiting of the corresponding protective line (1, 2, 3).

13. Protection circuit for protecting an electrical circuit accommodated in a housing against intrusions according to Claim 11 or 12, **characterised in that**, in the switched-off state of the electrical circuit, the signal detection device (7, 8, 9) detects a voltage applied to the protective line (1, 2, 3) and generates a warning signal.

## Revendications

1. Circuit de protection pour protéger d'intrusions un circuit électrique logé dans un boîtier, comprenant une pluralité de lignes (1, 2, 3) de protection s'étendant dans le boîtier, un dispositif (18) de commande et une pluralité d'éléments (10, 11) de commutation qui sont reliés au dispositif (18) de commande, les éléments (10, 11) de commutation
- étant, lorsque le circuit électrique est sous tension, bloqués par le dispositif (18) de commande et,
- plusieurs lignes (1, 2, 3) de protection étant reliées les unes aux autres lorsque le circuit électrique est hors tension.

2. Circuit de protection pour protéger d'intrusions un circuit électrique logé dans un boîtier suivant la revendication 1,
**caractérisé**
**en ce que** les éléments (10, 11) de commutation relient entre elles toutes les lignes de protection.

3. Circuit de protection pour protéger d'intrusions un circuit électrique logé dans un boîtier suivant la revendication 1 ou 2,
**caractérisé**
**en ce que** le circuit électrique est un circuit intégré dans le boîtier.

4. Circuit de protection pour protéger d'intrusions un circuit électrique logé dans un boîtier suivant l'une des revendications précédentes,
**caractérisé**
**en ce que** les lignes (1, 2, 3) de protection s'étendent sinueusement à la surface du boîtier.

5. Circuit de protection pour protéger d'intrusions un circuit électrique logé dans un boîtier suivant l'une des revendications précédentes,
**caractérisé**
**en ce que** les lignes (1, 2, 3) de protection s'étendent dans divers plans de métallisation du circuit intégré.

6. Circuit de protection pour protéger d'intrusions un circuit électrique logé dans un boîtier suivant l'une des revendications précédentes,
**caractérisé**
**en ce que** les éléments (10, 11) de commutation sont, lorsque le circuit électrique est sous tension, bloqués par un dispositif (18) de commande.

7. Circuit de protection pour protéger d'intrusions un circuit électrique logé dans un boîtier suivant l'une des revendications précédentes,
**caractérisé**
**en ce que** chaque élément (10, 11) de commutation est relié au dispositif (18) de commande par une ligne de commande propre.

8. Circuit de protection pour protéger d'intrusions un circuit électrique logé dans un boîtier suivant l'une des revendications précédentes 1 à 6,
**caractérisé**
**en ce que** plusieurs groupes d'éléments (10, 11) de commutation sont reliés au dispositif de commande respectivement par une ligne de commande.

9. Circuit de protection pour protéger d'intrusions un circuit électrique logé dans un boîtier suivant l'une des revendications précédentes,
**caractérisé**
**en ce** les éléments (10, 11) de commutation sont des transistors.

10. Circuit de protection pour protéger d'intrusions un circuit électrique logé dans un boîtier suivant la revendication 9,
**caractérisé**
**en ce que** les transistors sont des transistors à effet de champs à déplétion.

11. Circuit de protection pour protéger d'intrusions un circuit électrique logé dans un boîtier suivant l'une des revendications précédentes,
**caractérisé**
**en ce que** les lignes (1, 2, 3) de protection relient respectivement un dispositif (4, 5, 6) d'injection de signal à un dispositif (7, 8, 9) de détection de signal.

12. Circuit de protection pour protéger d'intrusions un circuit électrique logé dans un boîtier suivant la revendication 11,
**caractérisé**
**en ce que** le dispositif (7, 8, 9) de détection de signal détecte une différence de temps de parcours en cas de court-circuit de la ligne (1, 2, 3) de protection associée.

13. Circuit de protection pour protéger d'intrusions un circuit électrique logé dans un boîtier suivant la revendication 11 ou 12,
**caractérisé**
**en ce que** lorsque le circuit est hors tension, le dispositif (7, 8, 9) de détection de signal détecte une tension appliquée à la ligne (1, 2, 3) de protection et produit un signal d'avertissement.
